(19) Europäisches Patentamt
European Patent Office
Office européen des brevets

(11) Publication number: **0 058 068 B1**

(12) **EUROPEAN PATENT SPECIFICATION**

(45) Date of publication of patent specification: **31.10.90**

(51) Int. Cl.[5]: **H 01 L 23/14**, H 01 L 23/00

(21) Application number: **82300596.2**

(22) Date of filing: **08.02.82**

# (54) Integrated circuit chip carrier.

(30) Priority: **09.02.81 GB 8103840**

(43) Date of publication of application: **18.08.82 Bulletin 82/33**

(45) Publication of the grant of the patent: **31.10.90 Bulletin 90/44**

(84) Designated Contracting States: **BE DE FR GB IT SE**

(56) References cited:
**FR-A-2 439 438**
**JP-A-5 384 681**
**JP-A-53 114 067**

**COMPUTER, vol. 10, no. 12, December 1977, pages 58-68, Long Beach (USA); PROCEEDINGS of the TECHNICAL PROGRAM - National Electronic Packaging and Production Conference, pages 57-64: "Mini-Pak a Cost Effective Leadless Chip Carrier"**

(73) Proprietor: **BRITISH TELECOMMUNICATIONS public limited company**
**81 Newgate Street**
**London EC1A 7AJ (GB)**

(72) Inventor: **Sinnadurai, Francis Nihal**
**1 Moorfield Road**
**Woodbridge Suffolk, IP12 4JN (GB)**
Inventor: **Cook, James Anthony**
**The Meads Dora's Green Lane**
**Dippenhall Nr. Farnham, Surrey (GB)**
Inventor: **Gurnett, William Keith**
**44 Makepeace Road**
**Bracknell Berkshire (GB)**

(74) Representative: **Roberts, Simon Christopher et al**
**BRITISH TELECOM Intellectual Property Unit**
**13th Floor 151, Gower Street**
**London, WC1E 6BA (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 058 068 B1

(56) References cited:

**IEEE Transactions on components, Hybrids, and Manufacturing Technology, vol. CHMT-8, no. 3, September 1985, pages 386-390**
**Electronics weekly, 7-10-87, Seite 39**

**IEEE Transactions on components, Hybrids, and Manufacturing Technology, vol. CHMT-8, no. 3, September 1985, pages 386-390**
**Electronics weekly, 7-10-87, Seite 39**

**IEEE Transactions on components, Hybrids, and Manufacturing Technology, vol. CHMT-8, no. 3, September 1985, pages 386-390**
**Electronics weekly, 7-10-87, Seite 39**

## Description

This invention relates to an integrated circuit chip carrier. More particularly it relates to a chip carrier made from a plastics material.

Known forms of chip carrier consist of a usually rectangular base of ceramic material. A central area on the base is provided on to which an integrated circuit chip or die is mounted and secured, for example using an epoxy resin adhesive. Leads are then connected between the appropriate points on the die to metal bonding pads provided on the carrier base. A preformed metallization pattern on the carrier base connects the bonding pads to terminal contacts formed around the periphery of the base. A metal or ceramic lid is then secured over the base so as to enclose and protect the die. The ceramic chip carrier is thereafter mounted on a printed circuit board together with a series of other chip carriers and electronic components that go to form the complete circuit.

The use of ceramic material for the chip carrier is expensive and problems can also arise when the ceramic base is later bonded to a conventional epoxy/glass printed circuit board, due to the differential expansion between the two materials. In extreme environmental conditions the ceramic chip carrier can break away from the printed circuit board.

A particular ceramic chip carrier is described in the Japanese patent application No. 53-84681, of Sato. Described in the application is the manufacture of chip carriers in batches using a ceramic substrate. The substrate is provided with a series of rectangular arrays of perforations, each of the arrays defining an individual chip carrier. Through-hole printing with molybdenum or tungsten is used to render the walls of the perforations conductive. As a separate step, conductive pads are printed on the obverse and reverse of the substrate to connect with the conductive walls of the perforations. An insulating sheet, in the form of a lattice, is laid on the substrate with the lattice walls overlying the substrate's perforations, the holes in the lattice defining chip mounting sites on the substrate. After wire bonding and encapsulating the chips, the array is broken apart into individual chip carriers.

As with other ceramic chip carriers, that of Sato suffers from the inherent disadvantages of expense of materials and processing and problems of differential thermal expansion if used on non-ceramic circuit boards without a socket. A further disadvantage of the Sato structure is that accurate registration is needed during the two separate printing stages.

There is also known, from UK Patent Application 2,047,474A, a package for mounting a tape automated bonded (TAB) integrated circuit. The package is based around a segment of a flexible plastics TAB tape which includes metal interconnects and an integrated circuit chip. Plastics side walls are bonded to the segment to provide reinforcement for the flexible tape. An insulating encapsulant is also provided, to protect the chip.

The disclosure of GB 2,047,474A is solely concerned with the use of TAB chips, principally for use in credit cards, where the thickness available for receiving a chip is severely limited, and where the thinness of TAB tape is advantageous.

The invention is defined in the claims.

A preferred embodiment of the invention will now be described with reference to the accompanying drawings in which:

Figure 1 is a plan view of part of an array of chip carriers before separation shown at approximately three times actual size.

Figure 2 is an enlarged cross sectional view taken along the line A—A of Figure 1.

A series of chip carriers according to the invention are formed from a base sheet 10 of a glass reinforced epoxy resin such as is conventionally used in printed circuit board manufacture.

The base sheet 10 is formed with a series of rectangular arrays of metal pads 12, each of the arrays defining an individual chip carrier. A series of holes are formed in the sheet 10, one of which is shown at 14 in Figure 2. A plated through metallization 16 formed in each of the holes 14 connects each of the pads 12 to a corresponding pad 18 on the underside of the sheet 10. The pads 12 and 18 and the plated-through metallization 16 are all formed by conventional techniques used in printed circuit board manufacture, and are preferably formed of copper plated with gold or a nickel-gold alloy.

A grid 20 formed of the same material as the base 10, is bonded to the base 10, the arms 22 of the grid extending over the lines of holes 14 and over the portion on the metallization 16 formed on the upper surface of the base 10.

A series of integrated circuit dice 24 are then bonded onto base 10 in the centre of each of the arrays formed by the pads 12. Only a single die 24 is shown in Figure 1 but it is to be understood that a die will be mounted in each of the eight illustrated arrays. The die 24 is preferably bonded to the base 10 by means of an epoxy adhesive compatible with the material of the base 10. Leads 26 are then connected between the appropriate points on the die 24 and each of the pads 12, in a process known as "wire bonding". The number and disposition of the pads 12 can be determined in advance so as to correspond to the external connections on the die 24.

It can be seen from Figure 2 that each of the dice 24 is positioned in a cavity or depression formed by the arms 22 of the grid 20. This cavity can be filled with a layer of coating material made of a plastics material, which serves to enclose and protect the die 24. Thereafter a cover sheet (not shown) preferably formed of the same material as the base 10, may be secured over the grid 20 to form a protective cover (known as a "lid") for each of the chip carriers. Alternatively, a further layer of the coating material could be applied instead of a lid.

Once the dice 24 have been mounted and the appropriate protective covering has been applied, the whole array is then separated to form the individual chip carriers. This is done by cutting with a diamond saw along the centre lines of the arms 22 of the grid 20, on the axis X—X shown in Figure 2. The resulting individual, leadless chip carriers can be mounted on printed circuit boards, together with other circuit components, using the pads 18 to interconnect to a preformed metallization pattern on the circuit board in known manner.

It can be appreciated that the mounting of the circuit dice 24 and the subsequent processing up to the point at which the individual chip carriers are separated is carried out with an array which is much easier to handle than are the individual chip carriers, and which can readily be processed by automatic assembly apparatus.

The chip carriers in which the circuit dice are protected as described have exhibited high reliability in conditions of high humidity. Complete packages have been successfully tested at 90% relative humidity and 110°C for 2,000 hours.

**Claims**

1. A method of forming a chip carrier comprising the steps of:

a) providing a base sheet (10) having respective mutually aligned two-dimensional repeating metallization patterns (12, 18) on opposite surfaces thereof, said metallization patterns being electrically connected by a lattice of plated through-holes (16) formed in said base sheet;

b) attaching a grid (20) to one of said surfaces such that the arms (22) of the grid register with and cover the plated through-holes and

c) separating the resulting assembly (Fig. 1) along the lines of said lattice so as to form individual chip carriers each having portions of the plated through-holes around its periphery, characterised in that the base sheet (10) and grid (20) are both formed of glass re-inforced epoxy resin, that the metallization patterns (12, 18) are formed by printed circuit board technology and separation is by sawing with a diamond saw along the lines of said lattice to form the individual chip carriers.

2. A method as claimed in claim 1, further characterised in that said plated through-holes (16) are connected to respective metallization tracks (12) on said one surface which extend between two and only two grid apertures on opposite sides of their overlying grid arm.

3. A method as claimed in claim 1 or claim 2, further characterised in that said metallization patterns (12, 18) are composed of copper.

4. A method as claimed in claim 3 wherein at least one of said metallization patterns (12, 18) is coated with gold or a nickel-gold alloy.

5. A method as claimed in any preceding claim, wherein integrated circuit dice (24) are located within grid apertures and, before said step c) are electrically connected by a wire bonding to respective tracks of the metallization pattern (12) on said one surface.

6. A method as claimed in claim 5 wherein, after said wire bonding step but before said step c) a filling of protective plastics material is introduced into the grid apertures so as to cover the integrated circuit dice.

7. An electronic package having a chip carrier made according to claim 1 and an integrated circuit die, which comprises the integrated circuit die (24) mounted on one face of a base (10) of insulating material, a first metallization pattern (12) formed on said face and comprising a plurality of tracks of conductive material electrically connected to and extending from the region of the integrated circuit die to edges of the base, a second metallization pattern (18) on the opposite face of the base at the periphery thereof, metal-plated recesses in the periphery of the base extending between and electrically connecting tracks of the first and second metallization patterns, a side wall (22) located on said one face of the base (10) at the periphery thereof, over said first metallization pattern (12) and having an outer edge which is flush with an outer edge of the base and with severed metal of said metal-plated recesses, a protective layer of plastics material encapsulating the integrated circuit die on the base, characterized by said base and side wall being composed of a glass re-inforced epoxy resin, the metallization patterns having been formed by a printed circuit board technique and said outer edges and severed metal being defined by a common diamond sawn face.

**Patentansprüche**

1. Verfahren zum Bilden eines Chipträgers, die Schritte aufweisend:

a) Vorsehen eines Basisblatts (10) mit jeweils gegenseitig ausgerichteten zweidimensionalen sich wiederholenden Metallisierungsmustern (12, 18) auf seinen entgegengesetzten Oberflächen, wobei die Metallisierungsmuster durch ein Raster beschichteter Durchgangslöcher (16), die in dem Basisblatt gebildet sind, elektrisch verbunden sind;

b) Anbringen eines Gitters (20) an eine der Oberflächen, so daß die Arme (22) des Gitters zu den beschichteten Durchgangslöchern passen und sie überdecken; und

c) Trennen der resultierenden Anordnung (Figur 1) entlang den Linien des Rasters um einzelne Chipträger zu bilden, von denen jeder Abschnitte der beschichteten Durchgangslöcher um seinen Umfang aufweist, dadurch gekennzeichnet, daß das Basisblatt (10) und das Gitter (20) beide aus durch Glas verstärktes Epoxydharz gebildet sind, daß die Metallisierungsmuster (12, 18) durch eine Technologie für gedruckte Schaltungen gebildet werden und die Trennung durch Sägen mit einer Diamantsäge entlang den Linien des Rasters erfolgt, um die einzelnen Chipträger zu bilden.

2. Verfahren nach Anspruch 1, dadurch gekennzeichnet, daß die beschichteten Durchgangslöcher (16) mit jeweiligen Metallisierungsspuren (12) auf der einen Oberfläche verbunden sind, die sich zwischen zwei und nur zwei Gitteröffnungen auf entgegengesetzten Seiten ihrer überlagernden Gitterarme erstreckt.

3. Verfahren nach Anspruch 1 oder 2, dadurch gekennzeichnet, daß die Metallisierungsmuster (12, 18) aus Kupfer zusammengesetzt sind.

4. Verfahren nach Anspruch 3, wobei zumindest eines der Metallisierungsmuster (12, 18) mit Gold oder einer Nickel-Goldlegierung überdeckt ist.

5. Verfahren nach einem der vorangehenden Ansprüche, wobei integrierte Schaltungs-Stücke (24) innerhalb der Gitteröffnungen eingesetzt werden und vor dem Schritt c) durch eine Drahtverbindung mit jeweiligen Spuren des Metallisierungsmusters (12) auf der einen Oberfläche elektrisch verbunden werden.

6. Verfahren nach Anspruch 5, wobei nach dem Drahtverbindungsschritt aber vor dem Schritt c), eine Füllung eines schützenden Kunststoffmaterials in die Gitteröffnungen eingeführt wird, um die integrierten Schaltungs-Stücke zu bedekken.

7. Elektronik-Gehäuse mit einem Chipträger, der gemäß dem Anspruch 1 hergestellt ist und mit einem integrierten Schaltungs-Stück, wobei der Chip-träger das integrierte Schaltungs-Stück (24) enthält, das auf einer Seite einer Basis (10) eines Isoliermaterials befestigt ist, ein erstes Metallisierungsmuster (12), das auf der Seite gebildet ist, und eine Vielzahl von Spuren eines leitenden Materials enthält, das elektrisch verbunden ist mit und sich erstreckt von dem Bereich des integrierten Schaltungs-Stücks zu den Kanten der Basis, ein zweites Metallisierungsmuster (18) auf der entgegengesetzten Seite der Basis an seiner Peripherie, metallbeschichtete Aussparungen in der Peripherie der Basis, die sich zwischen Spuren der ersten und zweiten Metallisierungsmuster erstrecken und mit ihnen elektrisch verbunden sind, eine Seitenwand (22), die auf der einen Seite der Basis (10) an seiner Peripherie angeordnet ist, über dem ersten Metallisierungsmuster (12) und eine äußere Kante hat, die mit einer äußeren Kante der Basis und mit abgetrenntem Metall der metallbeschichteten Aussparungen fluchtet, eine Schutzschicht aus Kunststoffmaterial, die das integrierte Schaltungs-Stück auf der Basis einkapselt, dadurch gekennzeichnet, daß die Basis und die Seitenwand aus glasverstärktem Epoxydharz zusammengesetzt sind, die Metallisierungsmuster durch eine Technik für gedruckte Schaltungen gebildet sind und die äußeren Kanten und das abgetrennte Metall durch eine gemeinsame, mit Diamant gesägte Seite bestimmt ist.

**Revendications**

1. Un procédé de fabrication d'un support de microplaquette comprenant les étapes consistant à:

a) disposer une feuille de base (10) présentant sur ses surfaces opposés des configurations (12, 18) de métallisation répétitives, bidimensionnelles, respectivement alignées les unes par rapport aux autres, lesdites configurations de métallisation étant reliées électriquement par un réseau de trous traversants plaqués (16) ménagés dans ladite feuille de base;

b) attacher une grille (20) à l'une desdites surfaces de telle façon que les bras (22) de la grille soient alignés avec les trous traversants plaqués et les recouvrent et

c) séparer l'ensemble qui en résulte (Fig. 1) le long des lignes dudit réseau de façon à former des supports individuels de microplaquettes, chacun possédant autour de sa périphérie des parties des trous traversants plaqués, caractérisé en ce que la feuille de base (10) et la grille (20) sont l'une et l'autre formées de résine époxy armée de verre, en ce que les configurations de métallisation (12, 18) sont formées par technologie de plaque de circuit imprimé et en ce que la séparation est effectuée par sciage à la scie diamantée le long des lignes dudit réseau pour former les supports individuels de microplaquettes.

2. Un procédé selon la revendication 1, caractérisé en outre en ce que lesdits trous traversants plaqués (16) sont reliés sur ladite première surface à des pistes respectives de métallisation (12) qui s'étendent entre deux et seulement deux ouvertures de grille sur des côtés opposés du bras de grille qui les recouvre.

3. Un procédé selon la revendication 1 ou la revendication 2, caractérisé en outre en ce que lesdites configurations de métallisation (12, 18) sont en cuivre.

4. Un procédé selon la revendication 3 dans lequel au moins l'une desdites configurations de métallisation (12, 18) est revêtue d'or ou d'un alliage nickel-or.

5. Un procédé selon l'une quelconque des précédentes revendications, dans lequel des puces de circuit intégré (24) sont situées à l'intérieur des ouvertures de grille et, avant ladite étape c), sont reliées électriquement par soudure de fil à des pistes respectives de la configuration de métallisation (12) sur ladite première surface.

6. Un procédé selon la revendication 5 dans lequel, après ladite étape de soudure de fil mais avant ladite étape c) une charge de matière plastique protectrice est introduite dans les ouvertures de grille de façon à couvrir les puces de circuit intégré.

7. Un ensemble électronique comportant un support de microplaquette formé selon la revendication 1 et une puce de circuit intégré, qui comprend la puce de circuit intégré (24) montée sur une face d'une base (10) en matière isolante, une première configuration de métallisation (12) formée sur ladite face et comprenant plusieurs pistes de matière électriquement conductrice reliées à la zone de la puce de circuit intégré et s'étendant depuis cette zone vers les bords de la base, une deuxième configuration de métallisation (18) sur la face opposée de la base à la périphérie de celle-ci, des évidements plaqués de métal dans la périphérie de la base s'étendant entre des pistes des première et deuxième configurations de métallisation et reliant électriquement ces pistes, une paroi latérale (22) située sur ladite première face de la base (10) à la périphérie de celle-ci, au-dessus de ladite première configuration de métallisation (12) et possédant un bord extérieur qui affleure avec un bord extérieur de la base et avec du métal coupé desdits évidements plaqués de métal, une couche protectrice de matière plastique encapsulant la puce de circuit intégré sur la base, caractérisé en ce que ladite base et ladite paroi latérale sont en résine époxy armée de verre, en ce que les configurations de métallisation ont été formées par une technique de plaque de circuit imprimé et en ce que lesdits bords extérieurs et ledit métal découpé sont définis par une face commune sciée à la scie diamantée.

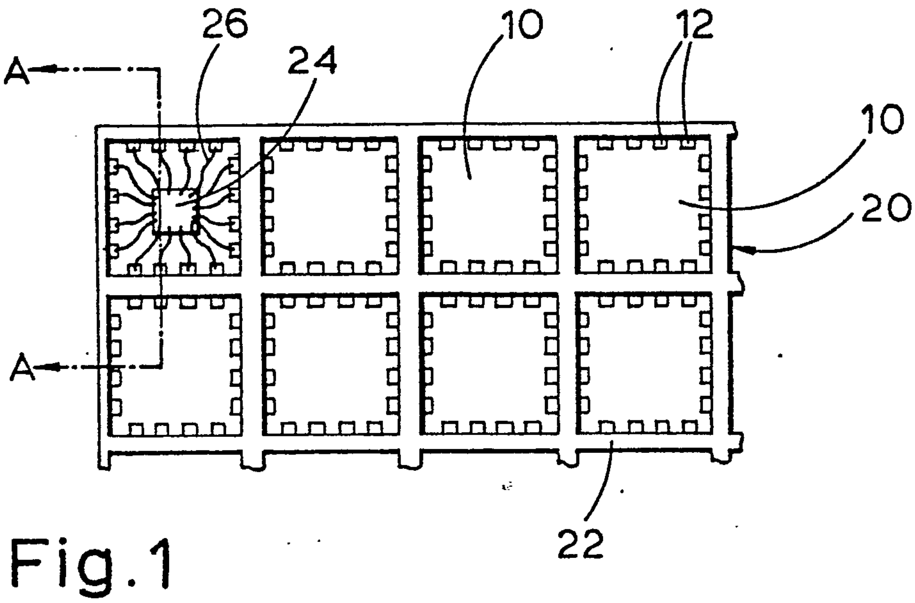


Fig.1

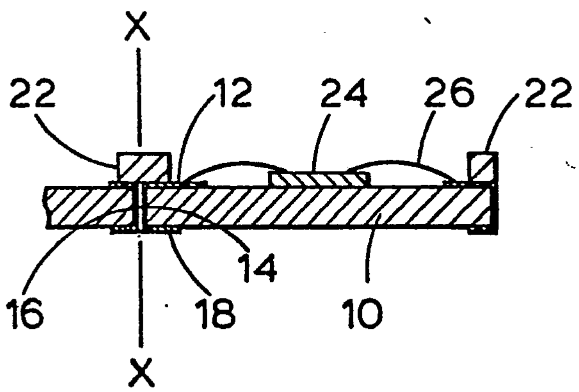


Fig.2